# EUROPEAN PATENT SPECIFICATION

(11) **EP 3 446 344 B1**
(45) Date of publication and mention of the grant of the patent: **17.06.2020**
(21) Application number: 17743073.3
(22) Date of filing: 14.07.2017
(51) Int. Cl.: H01L 51/42, H01G 9/20

(54) **SOLAR CELL MATERIALS FOR INCREASED EFFICIENCY**
SOLARZELLENMATERIALIEN MIT VERBESSERTER EFFIZIENZ
MATÉRIAUX DE CELLULES SOLAIRES POUR EFFICACITÉ ACCRUE

(30) Priority: 15.07.2016 US 201662362881 P; 15.07.2016 US 201662362894 P; 15.05.2017 US 201762506272 P
(43) Date of publication of application: 27.02.2019
(73) Proprietor: Tronox Pigment UK Limited, London EC3A 6AP (GB)
(72) Inventor: MCINTYRE, Robert, Grimsby North East Lincolnshire DN40 2PR (GB); WAGSTAFF, Anthony, Grimsby North East Lincolnshire DN40 2PR (GB); KERROD, Julie, Grimsby North East Lincolnshire DN40 2PR (GB); MOORE, Christopher, St. Asaph Denbighshire LL17 0RN (GB); AHMED, Syed Zaka, St. Asaph Denbighshire LL17 0RN (GB)
(74) Representative: Cockerton, Bruce Roger
(86) International application number: PCT/GB2017/052082
(87) International publication number: WO 2018/011597

(56) References cited:
- WO-A1-2015/164731
- JULIAN BURSCHKA ET AL: "Sequential deposition as a route to high-performance perovskite-sensitized solar cells", NATURE, vol. 499, no. 7458, 10 July 2013 (2013-07-10), pages 316-319, XP55131813, ISSN: 0028-0836, DOI: 10.1038/nature12340
- H. ZHOU ET AL: "Interface engineering of highly efficient perovskite solar cells", SCIENCE, vol. 345, no. 6196, 1 August 2014 (2014-08-01), pages 542-546, XP55412074, ISSN: 0036-8075, DOI: 10.1126/science.1254050

## Description

### BACKGROUND

In the field of photovoltaics, there is a need to develop alternative technology to broaden the use of solar cells as an energy source. Traditional crystalline silicon solar cells are well established, but have the disadvantages of high costs (often requiring government subsidies to make their use cost-effective), requiring a thicker layer to accommodate appropriate photon capture when using silicon technology and being subjected to the fragile nature of silicon itself, which often requires means to protect the silicon based cells (e.g. use of bulky solar panels with bulk proportional to the amount of energy generated).

Efforts to modify traditional silicon technology to enhance their widespread use (e.g. use of polycrystalline silicon or thin-film silicon solar cells) are often accompanied with a decrease in efficiency in transforming sunlight into energy, increase the complexity of the technology to be employed, increase the cost of employing the technology and/or fail to address the fragility problem of the silicon based cells, thereby counteracting any benefits gained.

Likewise, alternative solar cell technologies have their own inherent disadvantages, e.g. CIGS (copper-indium-gallium-selenide) thin-films lack the efficiency of silicon solar cells, CdTe thin-film solar cells require the use of highly toxic Cd and require Te which is not as abundant as Cd, etc.

Solar cell technology based on organometal trihalide perovskite combines the technical merits of dye-sensitized solar cells with that of thin film solar cells and represents a trend in solar cell development. Perovskite solar cells attracted a great deal attention due to a record high efficiency breakthrough (>21%) using organometal trihalide perovskite absorbers. Configurations include a mesoporous semiconducting metal oxide; a perovskite material; an optional hole transporting material (HTM) to transport positive charges (holes) from the perovskite to the counter electrode; and a metal counter electrode.

Mesoporous TiO₂ is a commonly used electron transport material. A mesoporous TiO₂ structure provides a sufficient internal surface area to which perovskite can interface to maximize light harvesting efficiency. The electron transfer from perovskite to the mesoporous TiO₂ electrode is faster than other recombination processes, but still has ample room for improvement.

Although mesoporous TiO₂ (mp-TiO₂) is considered crucial for perovskite solar cells (PSCs) as an electron transport material, mp-TiO₂ still has been less studied as surface modification for passivating interface of perovskite/mp-TiO₂.

While not wishing to be bound by theory, the dearth of studies could be related to the electron trapping at the interface between perovskite and TiO₂ layer which has a negative influence on charge recombination and charge transport. For example, in TiO₂ nanocrystals, electrons and holes are predicted to trap both in the bulk and near surface (see Di Valentin et al., J. Phys. Chem. Lett., 2011, 2: 2223-2228). The propensity for trapping can be explained in part by titania's very high dielectric constant. In contrast, electrons and holes do not appear to self-trap in other low dielectric oxide such as MgO. Theoretical calculations for TiO₂ suggest that electrons prefer to localize just below the surface while holes localize at uncoordinated surface oxygen ions (see Deskins et al., J. Phys. Chem. C, 2009, 113: 14583-14586; Ji et al., J. Phys. Chem. C, 2012, 116: 7863-7866).

In prior art perovskite solar cells, excitons and free charge carriers are generated within the organometal trihalide perovskite material through light absorption. Electrons are then injected into the conduction band of the electron transport material. A blocking layer blocks hole transport and conducts the electrons to an electrode, thence the external circuit. Hole transport proceeds from the valence band of the perovskite absorber to the hole transporting material (HTM) via charge "hopping" mechanisms, after which the holes are transported through the HTM to a metallic counter electrode. Other electron and hole travel can lead to recombination and reduced cell efficiency. Julian Burschka et al.: "Sequential deposition as a route to high-performance perovskite-sensitized solar cells", Nature 499 (2013) 316-319 describes a sequential deposition method for the formation of a perovskite pigment within a porous metal oxide film, where PbI₂ is first introduced from solution into a nanoporous titanium dioxide film and subsequently transformed into a perovskite by exposing it to a solution of CH₃NH₃I. WO 2015/164731 A1 provides solar cells which comprise an electron transporting layer and a light sensitizing layer of perovskite disposed over the surface of the electron transporting layer.

To this end, a need exists for a materials and cell design strategy to optimize the efficiency of electron transport from the perovskite to the conducting oxide and hole transfer from the perovskite to the hole transport material and to reduce the thickness of the photovoltaic cell to encourage widespread use. It is to such materials and cell designs that the inventive concepts disclosed herein are directed. As solar cells are well known to be a clean energy alternative to oil, coal or nuclear powered plants, the inventive concepts disclosed herein provide environmental and sustainability benefits.

### BRIEF DESCRIPTION OF THE DRAWINGS

The accompanying drawings, which are incorporated in and constitute a part of this specification, illustrate one or more implementations described herein and, together with the description, explain these implementations. The drawings are not intended to be drawn to scale, and certain features and certain views of the figures may be shown exaggerated, to scale or in schematic in the interest of clarity and conciseness. Not every component may be labeled in every drawing. Like reference numerals in the figures may represent and refer to the same or similar element or function. In the drawings:
FIG. 1A - FIG. 1C are cross-sections of a mesoporous titania particle having halogen or alkali metal halide and photoactive perovskite on the surface.
FIG. 2 is a diagram of an embodiment of a photovoltaic cell constructed in accordance with the inventive concepts disclosed herein.
FIG. 3 is a scanning electron microscope (SEM) micrograph of the materials in a photovoltaic cell similar to the cell depicted in FIG. 2.
FIG. 4 is a diagram of another embodiment of a photovoltaic cell in accordance with the inventive concepts disclosed herein.
FIG. 5 is a SEM micrograph of the materials in a photovoltaic cell similar to the cell depicted in FIG. 4.
FIG. 6 is a graph showing the average voltage vs current for the Example cells comparing halogenated and unhalogenated mesoporous titania.

### DETAILED DESCRIPTION

The invention is defined by the claims. Before explaining at least one embodiment of the presently disclosed inventive concept(s) in detail, it is to be unanatasderstood that the presently disclosed inventive concept(s) is not limited in its application to the details of construction and the methodologies set forth in the following description or illustrated in the drawings. The presently disclosed inventive concept(s) is capable of other embodiments or of being practiced or carried out in various ways. Also, it is to be understood that the phraseology and terminology employed herein is for the purpose of description and should not be regarded as limiting.

Unless otherwise defined herein, technical terms used in connection with the presently disclosed inventive concept(s) shall have the meanings that are commonly understood by those of ordinary skill in the art. Further, unless otherwise required by context, singular terms shall include pluralities and plural terms shall include the singular.

All of the articles and/or methods disclosed herein can be made and executed without undue experimentation in light of the present disclosure. While the articles and methods of the presently disclosed inventive concept(s) have been described in terms of preferred embodiments, it will be apparent to those of skill in the art that variations may be applied to the articles and/or methods and in the steps or in the sequence of steps of the method described herein without departing from the scope of the presently disclosed inventive concept(s).

As utilized in accordance with the present disclosure, the following terms, unless otherwise indicated, shall be understood to have the following meanings:

The use of the word "a" or "an" when used in conjunction with the term "comprising" in the claims and/or the specification may mean "one", but it is also consistent with the meaning of "one or more," "at least one," and "one or more than one." The use of the term "or" in the claims is used to mean "and/or" unless explicitly indicated to refer to alternatives only or that the alternatives are mutually exclusive, although the disclosure supports a definition that refers to only alternatives and "and/or." Throughout this application, the term "about" is used to indicate that a value includes the inherent variation of error for the device, the method being employed to determine the value, or the variation that exists among the study subjects. For example, but not by way of limitation, when the term "about" is utilized, the designated value may vary by plus or minus twelve percent, or eleven percent, or ten percent, or nine percent, or eight percent, or seven percent, or six percent, or five percent, or four percent, or three percent, or two percent, or one percent. The use of the term "at least one of X, Y, and Z" will be understood to include X alone, Y alone, and Z alone, as well as any combination of X, Y, and Z. The use of ordinal number terminology (i.e., "first," "second," "third," "fourth," etc.) is solely for the purpose of differentiating between two or more items and is not meant to imply any sequence or order or importance to one item over another or any order of addition, for example.

As used in this specification and claim(s), the words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps.

The term "or combinations thereof" as used herein refers to all permutations and combinations of the listed items preceding the term. For example, "A, B, C, or combinations thereof" is intended to include at least one of: A, B, C, AB, AC, BC, or ABC, and if order is important in a particular context, also BA, CA, CB, CBA, BCA, ACB, BAC, or CAB. Continuing with this example, expressly included are combinations that contain repeats of one or more item or term, such as BB, AAA, AAB, BBC, AAABCCCC, CBBAAA, CABABB, and so forth. The skilled artisan will understand that typically there is no limit on the number of items or terms in any combination, unless otherwise apparent from the context.

As used herein, the term "substantially" means that the subsequently described event or circumstance completely occurs or that the subsequently described event or circumstance occurs to a great extent or degree. For example, when associated with a particular event or circumstance, the term "substantially" means that the subsequently described event or circumstance occurs at least 80% of the time, or at least 85% of the time, or at least 90% of the time, or at least 95% of the time. The term "substantially adjacent" may mean that two items are 100% adjacent to one another, or that the two items are within close proximity to one another but not 100% adjacent to one another, or that a portion of one of the two items is not 100% adjacent to the other item but is within close proximity to the other item.

The term "associate" as used herein will be understood to refer to the direct or indirect connection of two or more items.

The term "mesoporous" as used herein will be understood to refer to a material containing pores having an average diameter between 1 nm and 100 nm.

The term "nanoparticle" as used herein will be understood to refer to a particle having a diameter less than 100 nm, or to particles having a weight average particle diameter less than 100 nm, as measured by dynamic light scattering or by TEM micrograph.

The "power conversion efficiency" (PCE) data presented in this application refers to testing of the semiconductor-absorber composite or the semiconductor-absorber composite as part of a single cell photovoltaic cell, not tandem or multiple junction cells.

Turning now to the presently disclosed inventive concept(s), certain embodiments thereof are directed to a semiconductor-absorber composite comprising a mesoporous titania particle having halogen atoms disposed on a surface of the particle, and a photoactive perovskite in physical contact with at least a portion of the surface of the mesoporous titania particle, and to methods of making the same. In one embodiment, the semiconductor-absorber composite comprising a mesoporous titania particle having Group 1 alkali metal halide or lead halide disposed on a surface of the particle, and a photoactive perovskite in physical contact with at least a portion of the metal halide-treated surface of the mesoporous titania particle, and to methods of making the same. Another embodiment includes the semiconductor-absorber composites having the photoactive perovskite in the voids between the mesoporous titania particles. Other embodiments of the presently disclosed inventive concept(s) are directed to the semiconductor-absorber composites additionally having a hole transport material in the voids between the mesoporous titania particles. Additional embodiments are directed to photovoltaic cells using such compositions. Yet other embodiments are directed to photovoltaic cells using a hole-blocking layer comprising titania particles with a halide or Group 1 alkali metal halide on the titania particle surface.

The presently disclosed inventive concept(s) possesses many benefits over the prior art. First, the efficiency of photovoltaic cells using a semiconductor-absorber composite comprising photoactive perovskite and mesoporous titania particles is improved by adding a halogen to the mesoporous titania particle surface. Secondly, the electrical contact between photoactive perovskite and mesoporous titania appears to be improved when a halide is present on the titania surface. Thirdly, the wettability between photoactive perovskite and mesoporous titania appears to be improved when a halide is present on the titania surface. Efficiencies are additionally improved by adding a Group 1 alkali metal halide or lead halide to the mesoporous titania particle surface. Certain embodiments of the presently disclosed inventive concept(s) will be described herein below with reference to the Drawings.

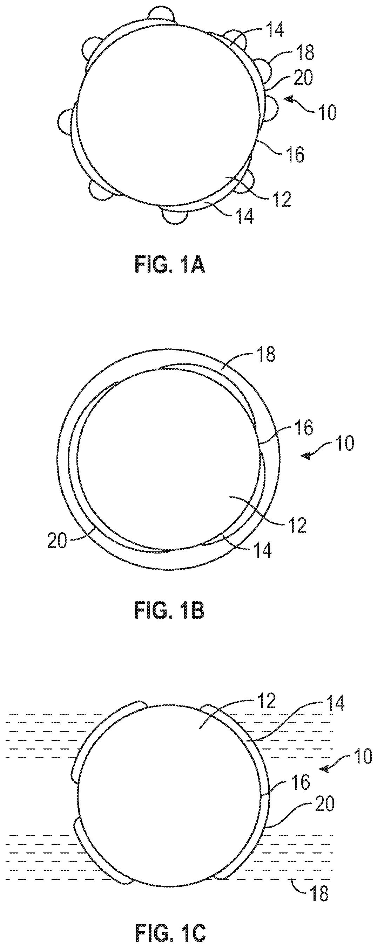

In one embodiment, a semiconductor-absorber composite 10 comprises a mesoporous titania particle 12 having halogen atoms on the particle surface 16 and photoactive perovskite 18 disposed on at least a portion of the halogenated surface 20 of the mesoporous titania particle 12. In one embodiment, the mesoporous titania particle 12 has an alkali metal halide or lead halide on the particle surface 16. Cross-sections of such a composite 10 are shown in FIG. 1A through FIG. 1C. In FIG. 1A, the mesoporous titania particle 12 has an outer layer 14 that is rich in halogen, or alkali metal halide, or lead halide (sometimes referred to as a halogenated surface or alkali metal halide-treated surface, or lead halide-treated surface respectively) and patches of the photoactive perovskite 18 acting as a light absorber and electron conductor on the halogenated surface or alkali metal halide-treated surface, or lead halide-treated surface 14 of the of the particle12. FIG. 1B shows a cross-section of a semiconductor-absorber composite wherein a thin continuous layer of perovskite 18 surrounds the particle, while FIG. 1C shows a semiconductor-absorber composite cross-section wherein the photoactive perovskite 18 surrounds the particle including adjacent void space.

In one embodiment, the semiconductor-absorber composite 10 comprises a mesoporous titania particle 12 having Group 1 alkali metal halide on the particle surface 16 and photoactive perovskite 18 disposed on at least a portion of the alkali metal halide-treated surface 20 of the mesoporous titania particle 12.

In one embodiment, the semiconductor-absorber composite 10 comprises a mesoporous titania particle 12 having lead halide on the particle surface 16 and photoactive perovskite 18 disposed on at least a portion of the alkali metal halide-treated surface 20 of the mesoporous titania particle 12.

In one embodiment, the mesoporous titania particles are predominantly anatase as determined by X-ray diffraction patterns. Titania is a stable, non-toxic material with high refractive index (n=2.4-2.5), and is widely used in our daily life, such as in white pigment, tooth paste, cosmetics or food. Naturally occurring titania has three main crystal phases: rutile, anatase and brookite. Anatase titania is quite suitable for photovoltaic cell applications because it has a greater energy band gap and higher conduction band than the other forms, and therefore can provide a higher potential cell efficiency. The phrase "predominantly anatase" is used herein to mean that the titania particles are at least 60 percent anatase, and can be greater than 95 percent anatase.

In one embodiment, the titania particles comprise nanoparticles. Nanoparticles offer an advantage of a high specific surface area for adsorption of light absorber precursor chemicals that form the perovskite. The average titania particle size can be, for example, between 1 and 100 nm, between 2 and 50 nm, between 40 and 80 nm or between 50-70 nm as measured by transmission electron microscopy (TEM). In a further embodiment, greater than 95% of the particles are within the stated particle size range; alternatively, greater than 98% of the particles are within the stated particle size range. Particles size measurements or ranges herein refer to a weight average particle diameter of a representative sample.

The pores within the mesoporous titania particles may be regular in size and shape and have a size of from 1 to 50 nm, from 2 to 40 nm, or no more than half the size of the particle size.

It was surprisingly discovered that the efficiency of solar cells using a layer(s) comprising photoactive perovskite on the surface of mesoporous titania particles was significantly improved with the addition of a halide to the surface of the mesoporous titania particles. While not being limited to any particular theory, it is thought that the replacement of hydroxyls on the titania surface with a halide provides a crystallization point for perovskite. This can enhance transfer of electrons generated by photo-excitation in the perovskite to the TiO₂ electron conductor. It may also improve the wettability of the perovskite on the TiO₂ surface. Both possible mechanisms should improve the efficiency of the photovoltaic cell as was observed.

It was also discovered that the efficiency of solar cells using a layer(s) comprising photoactive perovskite on the surface of mesoporous titania particles was quite significantly improved with the addition of a Group 1 alkali metal halide to the surface of the mesoporous titania particles.

The photoactive perovskite can be in the form of a thin continuous or discontinuous layer of perovskite on the surface of the halogenated, alkali metal halide-treated, or lead halide-treated mesoporous titania particles, and can fully or partly fill the pores of and between the mesoporous titania. In some embodiments, the photoactive perovskite can be present as discrete nano-sized particles or quantum dots.

The photoactive perovskite often comprises an organometal trihalide having a general formula of ABX₃; wherein A is a monovalent cation; B is a divalent transition metal cation; and X is usually one or more halide.

In one embodiment, the monovalent cation in the ABX₃ formula is a substituted ammonium cation with the general formula R¹R²R³R⁴N, wherein R is hydrogen, an alkane, an alkene, aromatic hydrocarbon, or combination thereof.

In another embodiment, the monovalent cation in the photoactive perovskite formula ABX₃ is an inorganic cation. Examples of suitable inorganic monovalent cations include, but are not limited to, potassium (K+), sodium (Na⁺), cesium (Cs⁺), lithium (Li+), and rubidium (Rb⁺).

Suitable divalent cations in the ABX₃ formula include, but are not limited to, Pb²⁺, Sn²⁺, Cu²⁺, Ge²⁺, Zn²⁺, Ni²⁺, Fe²⁺, Mn²⁺, Eu²⁺, Zr²⁺, or Co²⁺and combinations thereof. Suitable halides include F⁻, Cl⁻ , Br⁻, I⁻, and combinations thereof. For example, nonlimiting examples of suitable photoactive perovskite compositions include CH₃NH₃PbI₃, CH₃NH₃PbI₂Cl, CH₃NH₃ZnI₃, RbPbBr3, CsPbI₃ and the like.

In one embodiment, the photoactive perovskite comprises a compound having the formula [A][B][X]₃ wherein [A] is a monovalent cation, [B] is a divalent metal cation, [X] is a halide or mixture of halide anions, and this compound is doped with a Group 1 or Group 2 element. In another embodiment, the mesoporous titania is doped with a Group 1 or Group 2 element. In yet another embodiment, both the photoactive perovskite and the mesoporous titania are doped with a Group 1 or Group 2 element. It is anticipated that doping both the photoactive perovskite and the mesoporous titania will improve the stability and efficiency of photovoltaic cells incorporating such material.

In one embodiment, the photoactive perovskite comprises a compound having the formula [A][B][X]₃ wherein [A] is a monovalent cation, [B] is a divalent metal cation, [X] is a halide or mixture of halide anions, and this compound is doped with monovalent cesium cations, lithium cations, rubidium cations, or a combination of cesium, lithium and rubidium cations in the [A] position. In another embodiment, the mesoporous titania is doped with cesium, lithium, rubidium or a combination thereof. In yet another embodiment, both the photoactive perovskite and the mesoporous titania are doped with cesium, lithium, rubidium or a combination thereof.

In one embodiment, the semiconductor-absorber composite is dispersed in a hole transport material. Nonlimiting examples of suitable hole transport materials include 2,2',7,7'-tetrakis[N,N-di(4-methoxyphenyl)amino]-9,9'-spirobifiuorene (spiro-MeOTAD); poly(3-hexylthiophene-2,5-diyl) (P3HT); poly[2,6-(4,4-bis-(2-ethylhexyl)-4H-cyclopenta [2,I-*b*;3,4-*b'*)']dithiophene)-*alt*-4,7(2,I,3-benzothiadiazole)] (PCPDTBT); poly[bis(4-phenyl)(2,4,6-trimethylphenyl)amine] (PTAA)); and the like.

In one embodiment, the hole transport material comprises an inorganic oxide p-type semiconductor. Examples of suitable inorganic hole transport materials include, but are not limited to, NiO, CuO, Cu₂O, CuSCN (thiocyanate).

Mesoporous titania particles can be produced by wet chemical hydrolysis. For example, an aqueous solution of a water soluble compound of titanium can be formed at a concentration of from 0.5 to 1.5 moles per liter in the presence of an organic mineral acid and at an acid to titanium molar ratio of from 0.02 to 0.2. The aqueous solution can then be heated to a temperature in the range of from 70° C to 80° C and maintained at that temperature for a period of from 1 hour to 3 hours. The solution can then be heated to a temperature in the range of from 100° C up to the refluxing temperature and maintained at that temperature for an additional period of from 2 hours to 4 hours. The solution can then be cooled to room or ambient temperature, i.e., a temperature in the range of 25° C., and the reaction product separated and washed.

Any halogen can be added to the surface of the mesoporous titania particles. The halide compound used can be organic or inorganic and can be an acid or a salt. For example, the halogen can be an iodide, bromide, chloride, or fluoride acid or salt or combinations thereof. In one embodiment, the halide compound comprises hydrogen iodide.

In one embodiment, the halide compound used comprises a Group 1 alkali metal halide. Nonlimiting examples of suitable alkali metals include Li, Rb, and Cs. Nonlimiting examples of suitable alkali metal halides include LiI, CsI, RbI, LiCl, CsCl, RbCl, LiBr, CsBr, and RbBr.

In one embodiment, a lead halide is added to the surface of the mesoporous titania particles. Suitable lead halides include, but are not limited to, PbCl₂, PbI₂, PbBr₂, and combinations thereof.

In one embodiment, the halide compound is added to the aqueous gel of mesoporous titania nanoparticles produced as above. The resulting surface treated mesoporous titania can then be dried and milled.

In another embodiment, the halide compound is added to the bulk particles during manufacture of the mesoporous titania. For example, an aqueous solution of a water soluble titanium compound can be heated with a halide compound and an organic acid at an acid to titanium molar ratio of 0.02 to 0.2 as described above. After drying and milling, the resulting halide-containing mesoporous titania particles contain the halide or alkali metal halide on portions of the surface as well as in the bulk of the particles.

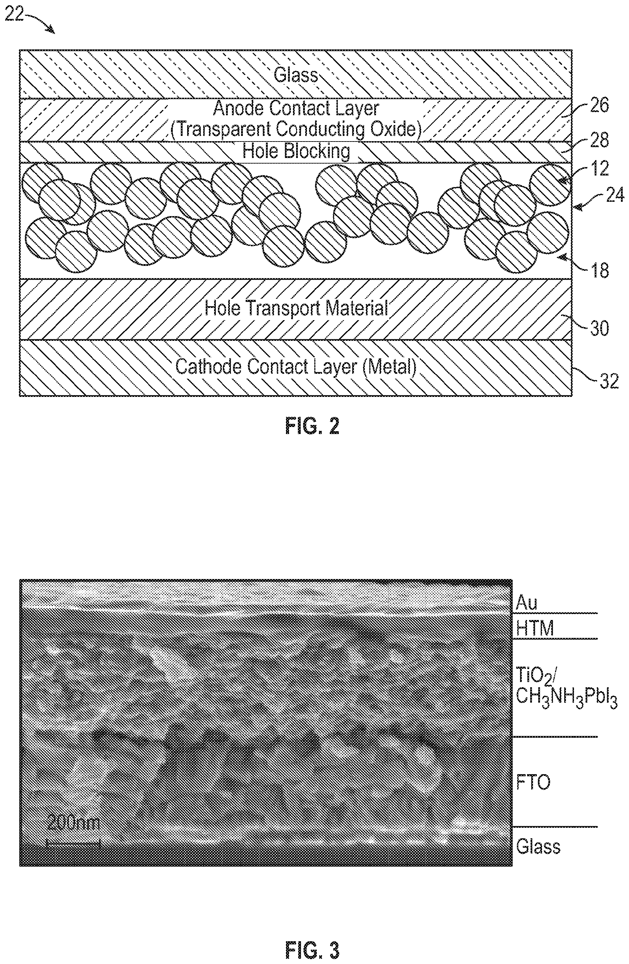

Referring now to FIG. 2, a photovoltaic cell 22 incorporating the above-described inventive concepts can include a light absorbing layer 24 comprising a photoactive perovskite 18 and mesoporous titania particles 12, an anode contact layer 26, and a hole blocking layer 28 between the light absorbing layer 24 and the anode contact layer 26. The hole blocking layer 28 includes an n-type oxide semi-conductor in electrical contact with the anode contact layer 26 and having halogen, alkali metal halide, or lead halide disposed on at least a portion of the surfaces thereof. While not being limited by any particular theory, it is believed that the halogen atom, the alkali metal atom, and the lead atom, each improve the electrical contact between the photoactive perovskite and the hole blocking layer which in turn improves the electron transfer. The light absorbing layer 24 can include a hole transport material 30 in electrical contact with the photoactive perovskite 18 and a cathode contact layer 32.

FIG. 3 shows a scanning electron microscope (SEM) micrograph of the materials in a photovoltaic cell 22 having an arrangement similar to the photovoltaic cell 22 in FIG. 2.

In one embodiment, the hole blocking layer 28 of a photovoltaic cell 22 comprises titania nanoparticles having a halogen, alkali metal halide, or lead halide disposed on at least a portion of the surfaces thereof. The halogen, alkali metal halide, and lead halide can be the same as described for the mesoporous titania and can be deposited on the surface or in the bulk of the particles.

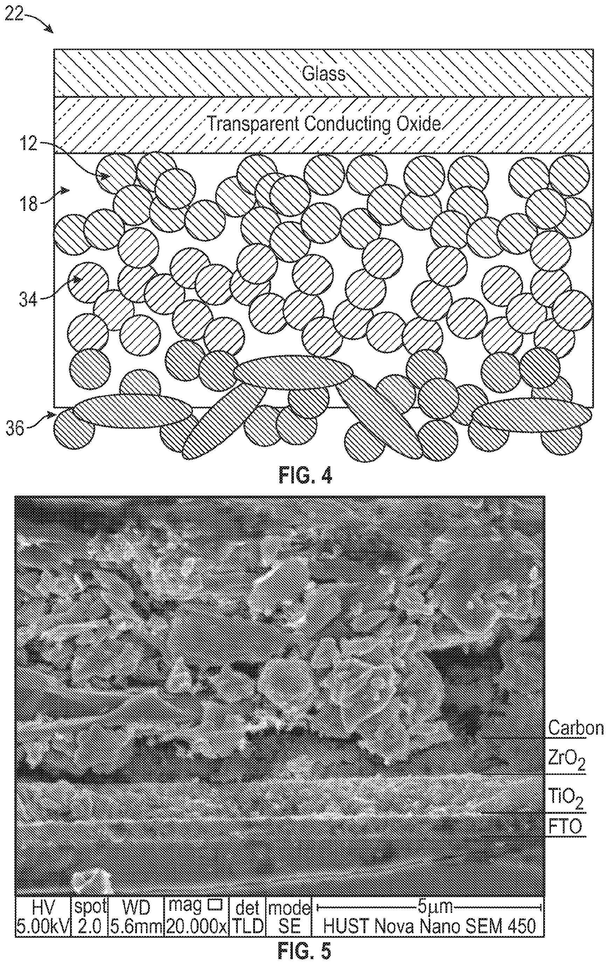

Another photovoltaic cell incorporating the above-described inventive concepts is shown in FIG. 4 and can include mesoporous titania particles 12, insulating metal oxide particles 34, halogen atoms, alkali metal halide, or lead halide disposed on a surface of the mesoporous titania particles 12 and the insulating metal oxide particles 34, and photoactive perovskite 18 in physical contact with at least a portion of the surfaces of the mesoporous titania particles 12 and the insulating metal oxide particles 34. The insulating metal oxide separates the mesoporous titania from a porous carbon particulate 36. FIG. 5 shows a SEM micrograph of the materials in similar cell. In this example the insulating metal oxide particles comprise mesoporous zirconia.

It will be understood by those skilled in the art that multiple cell designs can be utilized to take advantage of the increased cell efficiency provided by the halide as described above.

### EMBODIMENTS OF THE INVENTION

The numbered paragraphs below are non-limiting embodiments of the inventive concepts claiming benefit of this application. However, these paragraphs are to be understood to be presented for the purposes of illustration only and do not in any way limit the scope of the inventive concept(s) described or otherwise contemplated herein.
I. A semiconductor-absorber composite comprising:
   a mesoporous titania particle comprising anatase;
   halogen atoms disposed on a surface of the mesoporous titania particle; and
   photoactive perovskite in physical contact with at least a portion of the surface of the mesoporous titania particle, alternatively in physical contact with 50% to 100% of the surface, or alternatively in physical contact with the entire surface; wherein the halogen atoms comprise halide ions selected from the group consisting of iodide, bromide, chloride, fluoride, and combinations thereof in an amount of 0.005 - 6.0 wt%.
II. The semiconductor-absorber composite of embodiment I, further comprising at least one of lead and alkali metal atoms disposed on a surface of the mesoporous titania particle.
III. The semiconductor-absorber composite of embodiment I or embodiment II, wherein the mesoporous titania particle comprises anatase.
IV. The semiconductor-absorber composite of any one of embodiments I-III, wherein the mesoporous titania particle has a diameter between 2 and 100 nm, between 2 and 50 nm, between 40 and 80 nm or between 50-70 nm as measured by transmission electron microscopy (TEM) with greater than 95% of the particles are within the stated particle size range; alternatively, greater than 98% of the particles are within the stated particle size range.
V. The semiconductor-absorber composite of any one of embodiments I-IV, wherein the mesoporous titania particle has an average pore diameter of between 1 and 50 nm, from 2 to 40 nm, or no more than half the size of the particle size.
VI. The semiconductor-absorber composite of any one of embodiments I-V, wherein the halogen atoms comprise halide ions selected from the group consisting of iodide, bromide, chloride, fluoride, and combinations thereof in an amount selected from the group consisting of 1.0 - 5.0 wt%, 1.5 - 3.5 wt% and 0.015 - 1.5wt%.
VII. The semiconductor-absorber composite of any one of embodiments I-VI, wherein the halogen atoms comprise iodide.
VIII. The semiconductor-absorber composite of any one of embodiments II-VII, wherein the alkali metal atoms are selected from the group consisting of lithium, cesium, rubidium, and combinations thereof.
IX. The semiconductor-absorber composite of any one of embodiments I-VIII, wherein the halogen atoms are additionally dispersed in the bulk of the mesoporous titania particle.
X. The semiconductor-absorber composite of any one of embodiments II-IX, wherein the at least one of lead and alkali metal atoms are additionally dispersed in the bulk of the mesoporous titania particle.
XI. The semiconductor-absorber composite of any one of embodiments I-X, wherein the photoactive perovskite comprises a compound having the formula [A][B][X]₃ wherein [A] is a monovalent cation, [B] is a divalent metal cation, and [X] is a halide or mixture of halide anions.
XII. The semiconductor-absorber composite of any one of embodiments I-XI, wherein the photoactive perovskite comprises methyl ammonium lead trihalide.
XIII. The semiconductor-absorber composite of any one of embodiments I-XII, wherein the photoactive perovskite comprises methyl ammonium lead triiodide (MALI).
XIV. The semiconductor-absorber composite of any one of embodiments I-XI, wherein the photoactive perovskite comprises a compound having the formula [A][B][X]₃ wherein [A] is a monovalent cation, [B] is a divalent metal cation, [X] is a halide or mixture of halide anions, and the compound is doped with monovalent cations in the [A] position, wherein the monovalent cation is selected from the group consisting of cesium, lithium, rubidium, and combinations thereof.
XV. The semiconductor-absorber composite of any one of embodiments I-XI or XIV, wherein the mesoporous titania is doped with cations selected from the group consisting of cesium, lithium, rubidium, lead, and combinations thereof.
XVI. The semiconductor-absorber composite of any one of embodiments I-XV, wherein voids between the mesoporous titania particles are at least partly filled with the photoactive perovskite, alternatively 50% to 100% filled with photoactive perovskite, or alternatively completely filled with photoactive perovskite.
XVII. The semiconductor-absorber composite of any one of embodiments I-XV, wherein voids between the mesoporous titania particles are at least partly filled with a hole transport material, alternatively 50% to 100% filled with hole transport material, or alternatively completely filled with hole transport material.
XVIII. A method of making a semiconductor-absorber composite of any one of embodiments I-XV, comprising: mixing an aqueous gel of mesoporous titania nanoparticles with a halide compound to produce a surface treated mesoporous titania; drying and milling the surface treated mesoporous titania; and adding photosensitive perovskite to at least a portion of the surfaces of the surface treated mesoporous titania, alternatively adding photosensitive perovskite to 50% to 100% of the surface, or alternatively adding photosensitive perovskite to the entire surface.
XIX. The method of embodiment XVIII, wherein the halide compound is selected from the group consisting of iodides, chlorides, bromides, and combinations thereof.
XX. The method of embodiment XVIII or embodiment XIX, wherein the halide compound is selected from the group consisting of halide acids, halide salts, and combinations thereof.
XXI. The method of any one of embodiments XVIII-XX, wherein the halide compound comprises an organic halide.
XXII. The method of any one of embodiments XVIII-XX, wherein the halide compound comprises hydrogen iodide.
XXIII. The method of any one of embodiments XVIII-XX, wherein the halide compound comprises at least one of an alkaline metal halide and a lead halide.
XXIV. The method of embodiment XXIII, wherein the halide compound is selected from the group consisting of LiI, CsI, RbI, LiCl, CsCl, RbCl, LiBr, CsBr, RbBr, PbI₂, PbCl₂, PbBr₂ and combinations thereof.
XXV. A method of making the semiconductor-absorber composite of embodiment I, comprising: mixing an aqueous gel of mesoporous titania nanoparticles with a halide compound to produce a surface treated mesoporous titania; and drying and milling the surface treated mesoporous titania which optionally incorporates one of more of embodiments XIX - XXIV.
XXVI. A method of making a semiconductor-absorber composite of any one of embodiments I-XV, comprising: heating an aqueous solution of a water soluble titanium compound, an organic acid at an acid to titanium molar ratio of 0.02 to 0.2, and a halide compound to produce a halide-containing mesoporous titania; drying and milling the halide-containing mesoporous titania; and adding photosensitive perovskite to a portion of the surfaces of the halide-containing mesoporous titania, alternatively adding photosensitive perovskite to 50% to 100% of the surface, or alternatively adding photosensitive perovskite to the entire surface.
XXVII. The method of embodiment XXVI, wherein the halide compound is selected from the group consisting of iodides, chlorides, bromides, and combinations thereof.
XXVIII. The method of embodiment XXVI or embodiment XXVII, wherein the halide compound is selected from the group consisting of halide acids, halide salts, and combinations thereof.
XXIX. The method of any one of embodiments XXVI to XXVIII, wherein the halide compound comprises hydrogen iodide.
XXX. The method of any one of embodiments XXVI to XXVIII, wherein the halide compound comprises at least one of an alkaline metal halide and a lead halide.
XXXI. The method of embodiment any one of embodiments XXVI to XXVIII or XXX, wherein the halide compound is selected from the group consisting of LiI, CsI, RbI, LiCl, CsCl, RbCl, LiBr, CsBr, RbBr, PbI₂, PbCl₂, PbBr₂ and combinations thereof.
XXXII. A method of making a semiconductor-absorber composite, comprising:
   heating an aqueous solution of a water soluble titanium compound, an organic acid at an acid to titanium molar ratio of 0.02 to 0.2, and a halide compound to produce a halide-containing mesoporous titania;
   and drying and milling the halide-containing mesoporous titania which optionally incorporates one of more of embodiments XXVII to XXXI.
XXXIII. A composition comprising a hole transport material impregnating the semiconductor-absorber composite of any one of embodiments I to XV.
XXXIV. The composition of embodiment XXXIII, wherein the hole transport material comprises an organic compound selected from the group consisting 2,2',7,7'-tetrakis[N,N-di(4-methoxyphenyl)amino]-9,9'-spirobifiuorene (spiro-MeOTAD); poly(3-hexylthiophene-2,5-diyl) (P3HT); poly[2,6-(4,4-bis-(2-ethylhexyl)-4H-cyclopenta [2,I-*b*;3,4-*b*')']dithiophene)-*alt*,7(2,I,3-benzothiadiazole)] (PCPDTBT); and poly[bis(4-phenyl)(2,4,6-trimethylphenyl)amine] (PTAA)).
XXXV. The composition of embodiment XXXIII, wherein the hole transport material comprises an inorganic oxide p-type semiconductor.
XXXVI. A photovoltaic cell comprising:
   a light absorbing layer comprising a photoactive perovskite and mesoporous titania particles;
   an anode contact layer; and
   a hole blocking layer between the light absorbing layer and the anode contact layer, the hole blocking layer comprising an n-type oxide semi-conductor in electrical contact with the anode contact layers and having halogen atoms disposed on at least a portion of the surfaces thereof, alternatively disposed om 50% to 100% of the surface, or alternatively disposed on the entire surface.
XXXVII. The photovoltaic cell of embodiment XXXVI, wherein the hole blocking layers comprises titania nanoparticles having halogen atoms disposed on at least a portion of the surfaces thereof, alternatively disposed om 50% to 100% of the surface, or alternatively disposed on the entire surface.
XXXVIII. The photovoltaic cell of embodiment XXXVI or embodiment XXXVII, wherein halogen atoms comprise halide ions selected from the group consisting of iodide, bromide, fluoride, chloride, and combinations thereof in an amount selected from the group consisting of 0.005 - 6.0 wt%, 1.0 - 5.0 wt%, 1.5 - 3.5 wt% and 0.015 - 1.5wt%..
XXXIX. The photovoltaic cell of any one of embodiments XXXVI-XXXVIII, wherein the halogen atoms comprise iodide.
XL. The photovoltaic cell of any one of embodiments XXXVI-XXXIX, wherein the halogen atoms are additionally dispersed in the bulk of the mesoporous titania particle.
XLI. The photovoltaic cell of any one of embodiments XXXVI-XL, wherein the hole blocking layer further comprises at least one of alkali metal atoms and lead atoms disposed on at least a portion of the surfaces thereof.
XLII. The photovoltaic cell of embodiment XLI, wherein the alkali metal atoms are selected from the group consisting of Li, Cs, Rb, and combinations thereof.
XLIII. The photovoltaic cell of embodiment XLI or embodiment XLII, wherein the at least one of alkali metal atoms and lead atoms are additionally dispersed in the bulk of the mesoporous titania particle.
XLIV. The photovoltaic cell of any one of embodiments XXXVI-XLIII, wherein the photoactive perovskite comprises a compound having the formula [A][B][X]₃ wherein [A] is a monovalent cation, [B] is a divalent metal cation, and [X] is a halide or mixture of halide anions.
XLV. The photovoltaic cell of any one of embodiments XXXVI-XLIV, wherein the photoactive perovskite comprises methyl ammonium lead trihalide.
XLVI. The photovoltaic cell of any one of embodiments XXXVI-XLV, wherein the photoactive perovskite comprises a compound having the formula [A][B][X]₃ wherein [A] is a monovalent cation, [B] is a divalent metal cation, [X] is a halide or mixture of halide anions, and the compound is doped with monovalent cations in the [A] position, wherein the monovalent cations are selected from the group consisting of cesium, lithium, rubidium, and combinations thereof.
XLVII. The photovoltaic cell of any one of embodiments XXXVI-XLIII or embodiment XLVI, wherein the mesoporous titania is doped with at least one of lead ions and monovalent cations selected from the group consisting of cesium, lithium, rubidium, and combinations thereof.

In another embodiment of the invention, the semiconductor-absorber composite, composition and/or photovoltaic cell described above are free from non-perovskite dyes, moisture or both. (Being free from moisture means no added water or the removal of water to the extent possible when semiconductor-absorber composite, composition and/or photovoltaic cell is exposed to the atmosphere). To the extent a numerical range is necessary, free of water can mean between 0.001 w/w% to 0.00001 w/w% based on the total weight of the semiconductor-absorber composite, composition and/or photovoltaic cell.

In another embodiment of the invention, the described semiconductor-absorber composite also have utility for other solar cell applications, e.g. dye-sensitized solar cells (DSCs - Grätzel cells). In this embodiment of the invention, the semiconductor-absorber composite, composition and/or photovoltaic cells described above are used in conjunction with dyes as designed in DSCs.

In another embodiment of the invention, the use of semiconductor- absorber composite, composition and /or photovoltaic cells described above is applicable to wherever there is an excitation of electrons in the absorber and charge injected into the semiconductor thus separating the electron hole pairto create energy for electrical, photochemical, electrochemical or any other use e.g. as splitting water into hydrogen and oxygen or producing methanol from CO2 water.

In another embodiment of the invention, the photovoltaic cells of embodiments XXXVI - XLVIII have a power conversion efficiency (PCE) of at least 15%. In another aspect of this embodiment of the invention, the PCE is selected from a range consisting of 15% - 30%, 15% - 25% and 20% - 25%.

In another embodiment of the invention, the photovoltaic cells of embodiments XXXVI - XLVIII have a thickness of 0.25 - 15 microns, 0.4 - 10 microns or 0.8 - 5 microns (which refers to the thickness of the cell without measuring the thickness of the glass and cathode contact layer components of the photovoltaic cell.)

### EXAMPLES

In order to further illustrate the present invention, the following examples are given. However, it is to be understood that the examples are for illustrative purposes only and are not to be construed as limiting the scope of the invention.

Before delving into the details of the examples, it is instructive to note that the state of the art with respect to solar cells and semiconductors is such that even small improvements in activity or performance constitutes a major technological advance because of their macroscale applications.

By way of illustration, data from Energy Star (www.energystar.gov) referred to a study which estimated that a medium box retailer with 500 stores could save $2.5 million USD over three years (assuming a 2.4% cut in their energy bills per year during the three years). Writ larger on a national scale and from a different perspective, solar plants in China were estimated to have generated 66.2 billion kilowatt-hours of power in 2016; a 1% improvement in PCE from their solar plants could generate nearly 1 billion additional kilowatt-hours of power which is the equivalent of about 100+ small coal fired power plants (assuming an annual power generation of 8.76 million kilowatt hours (24,000 kw hours/day).

### Example 1

Mesoporous titania gel, (washed CristalACTiV™ GP350™ prior to spray drying) was modified by treating with hydrogen iodide to obtain a 5% mole fraction of iodide on the titania. CristalACTiV™ GP350™ is available from Cristal and is a mesoporous titania nanoparticulate. The gel was then dried for 12 hours at 105°C. The dried powder was milled in a planetary mill in terpineol at a solids concentration of 20%. Untreated GP350™ was dried and milled using the same conditions. Both the dried powder and Untreated GP350™ were free of water.

A comparison of GP350™ and the iodide-modified GP350™ was made using test cells with a spray-pyrolysis, 20 ml on hand polished fluorine-doped tin oxide (FTO); methyl ammonium lead triiodide (MALI) at 40 wt% in DMSO + chlorobenzene; and Spiro-MeOTAD plus FK209™ LiTFSI 10% as a hole transfer material. The FK209™ LiTFSI is a complexed lithium bis-trifluoromethanesulfonimide available from DyeSol. The top electrode was 90 nm gold. A plurality of samples were tested and averaged. The test results are shown in Table 1 below.

**Table 1. Treated and Untreated Mesoporous Titania (% PCE values)**

| Mesoporous TiO2 | Down Scan | Average | MPPT | Best Cell |
|---|---|---|---|---|
| Untreated | 12.05 | 10.32 | 9.95 | 13.69 |
| Iodide Treated | 14.83 | 12.29 | 12.43 | 16.04 |

| | | | | |
|---|---|---|---|---|
| MPPT - maximum power point tracking | | | | |

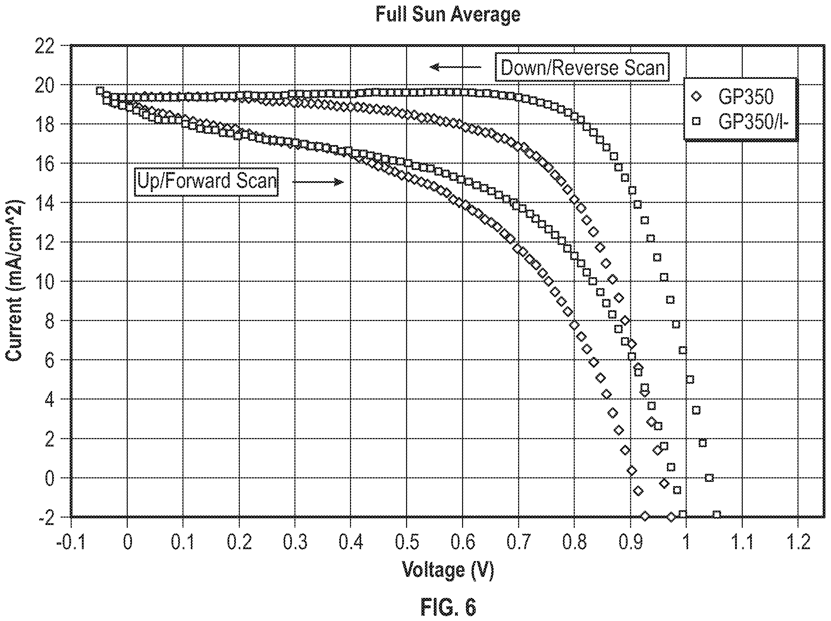

Voltage versus current plots are shown in FIG. 6. As can be seen, the halogen treated mesoporous titania performed significantly better than the untreated mesoporous titania.

### Example 2

Mesoporous titania gel was prepared using 1000g GP350™ at 13% TiO2 and placed under a mixer. Then 5.57g of lithium citrate was dissolved in 50g of demineralized water. The lithium citrated solution was added to the stirring gel over a 1 minute period. After complete addition, stirring was continued another 30 minutes. The doped gel was transferred to a glass tray, which was then placed in an oven at 105°C for 24 hours to dry. The glass tray was then removed from the oven and allowed to cool for 60 minutes and then ground in PULVERlSETTE™ 14 rotor mill at a speed setting of 16 using a 0.5mm sieve. The material was then transferred to a solid color container for storage during use. The material was free of water.

The resulting GP350™ doped with 5% mole ratio (0.4 wt%) was then be tested in photovoltaic test cells as described above and showed improved performance compared to untreated mesoporous titania.

### Example 3

Mesoporous titania gel was prepared using 500g GP350™ at 13% TiO2 and placed under a mixer. Then 11.6g of bis(trifluoromethane)sulfonimide lithium salt (LiTFSi) was dissolved in 50g of demineralized water. The LiTFSi solution was added to the stirring gel over a 1 minute period. After complete addition, stirring was continued for another 30 minutes. The doped gel was transferred to a glass tray, which was then placed in an oven at 105°C for 16 hours to dry. The glass tray was then removed from the oven and allowed to cool for 60 minutes and then ground in PULVERlSETTE™ 14 rotor mill at a speed setting of 16 using a 0.5mm sieve. The material was then transferred to a solid color container for storage during use. The material was free of water.

The resulting GP350™ doped at 5% mole ratio (0.4 wt%) can then be tested in photovoltaic test cells as described above showing improved performance compared to untreated mesoporous titania.

### Example 4

Mesoporous titania gel, (washed CristalACTiV™ GP350™ prior to spray drying) was modified by treating with a bromide compound to obtain a 5% mole fraction of bromide on the titania. In one case the bromide compound was HBr and in a second test bromide compound was tetraethylammonium bromide (TEABr). The gel dried and milled. Untreated GP350™ was dried and milled using the same conditions. The material was free of water.

A scoping comparison of untreated GP350™ and both bromide-modified GP350™ samples was made using Cs_{0.15}FA_{0.85}PbI_{2.49}Br_{0.51} perovskite. Results showed a 1.5% higher efficiency for both Br doped GP350™ samples.

### Example 5 - Cs doped mp-TiO₂ (5%)

*Cs-doping of TiO₂:* 5 wt% of CsX (X= I and Br) premixed mp-TiO₂ paste (Cristal HTX100i and HPX100b) was used for mp-TiO₂ layer which was deposited by spin coating for 20 s at 4000 rpm with a ramp of 2000 rpm per second to achieve a 150-200 nm thick layer. After the spin coating, the substrates were immediately dried at 100°C for 10 min and then sintered again at 450°C for 30 min under dry airflow. After cooling down to 150°C the substrates were immediately transferred in a nitrogen atmosphere glove box for depositing the perovskite films. The material was free of water.

### Example 6 - Characterization of Cs doped mp-TiO₂

Cs doped mp-TiO₂ films were prepared by sintering at 450°C for 30min with CsX premixed TiO₂ paste and subjected transmission electron microscope (TEM) imaging to analyze the mp-TiO₂ nanoparticles (NPs) with and without doping. The TiO₂ nanocrystals are mesoporous with an average size of 50 nm. After treatment with CsX, the morphology of the nanocrystals remained the same with Cs element well dispersed in TiO₂ structure, which was confirmed from scanning transmission electron microscopy (STEM) coupled with energy-dispersive X-ray spectroscopy (EDX) elemental mapping measurements, indicating successful and homogenous doping.

X-ray photoemission spectroscopy (XPS) was performed to further investigate the elemental composition of the Cs doped and undoped TiO₂. While not wishing to be bound by theory, it was presumed that Cs more predominantly affected these lower energy shifts than halides because the amount of halide on mp-TiO₂ is very minute compared to Cs. The peak shifts appear to indicate electron transfer to neighbor oxygen vacancies and partial reduction of Ti⁴⁺ to Ti³⁺ within the TiO₂ lattice. This can passivate the electronic defects or trap states that originate from oxygen vacancies resulting in improved charge transport properties. To study the impact of Cs doping on the charge transport within the mp-TiO₂, we prepared dye-sensitized solar cells (DSSCs) using Cs doped mp-TiO₂ as electron transporting layer, as the charge extraction measurement method is well-established to determine the density of state distribution below the TiO₂ conduction band.

Perovskite films prepared on mp-TiO₂ substrates with and with out CsX doping were analyzed via SEM and XRD; the similarities in grain sizes and diffraction patterns suggesting that doing did not affect crystal growth or morphology of perovskite films.

### Example 7 - Cs doped mp-TiO₂ (2% and 3%)

The procedure of Example 5 was repeated with 2 wt% and 3 wt% of CsBr premixed mp-TiO₂ paste. The material was free of water. Test cells were made similar to the procedures of Example 1 above.

**Table 2. Effect of Cs doping (2% and 3%)**

| Mesoporous TiO2 | Voc (V) | Jsc (mA/cm²) | FF | PCE (%) |
|---|---|---|---|---|
| Untreated | 1.001 | 23.1 | 0.74 | 17.3 |
| CsBr (2%) | 1.040 | 23.1 | 0.75 | 18.3 |
| CsBr (3%) | 1.044 | 23.0 | 0.74 | 18.1 |

| | | | | |
|---|---|---|---|---|
| Voc = open-circuit voltage Jsc = short-circuit current FF = fill factor PCE = power conversion efficiency | | | | |

### Example 7 - Photovoltaic cells preparation

*Substrate Preparation:* Nippon Sheet Glass 10 Ω/sq was cleaned by sonication in 2% Hellmanex water solution for 30 minutes. After rinsing with deionised water and ethanol, the substrates were further cleaned with UV ozone treatment for 15 min. Then, 30 nm TiO₂ compact layer was deposited on FTO via spray pyrolysis at 450°C from a precursor solution of titanium diisopropoxide bis(acetylacetonate) in anhydrous ethanol. After the spraying, the substrates were kept at 450°C for 45 min and left to cool down to room temperature.

An example of Cs doped TiO₂ is described above in Example 5.

*Perovskite precursor solution and film preparation:* The perovskite precursor were dissolved in anhydrous DMF:DMSO 4:1 (v:v). 10% excess PbI₂ and PbBr₂ were used for perovskite precursor solution. The *Rb*/*Cs*/*FA₁₋ₓMAₓ* perovskite precursor solutions were deposited from a precursor solution containing FAI (1-x) = formamidinium iodide, PbI₂, MABr = methylammonium bromide and PbBr₂ in anhydrous DMF:DMSO 4:1 (v:v) (x= 0, 0.05, 0.15).

Csl, predissolved as a 1.5 M stock solution in DMSO, was added to the mixed perovskite (FA/MA = formamidinium/methylammonium) precursor to make Cs/FA/MA triple cation perovskite. Rbl was also predissolved as a 1.5 M stock solution in DMF:DMSO 4:1 (v:v) and then was added to the Cs/FA/MA triple cation perovskite to achieve the desired quadruple composition. The perovskite solution was spin coated in a two steps program at 1000 and 4000 rpm for 10 and 20 s respectively. During the second step, 200 µL of chlorobenzene was poured on the spinning substrate 15 s prior to the end of the program. The substrates were then annealed at 100°C for 30min in a nitrogen filled glove box (for the device with annealed perovskite).

*Hole transporting layer and top electrode*: After the perovskite annealing, the substrates were cooled down for a few minutes and a spiro-OMeTAD solution (70 mM in chlorobenzene) was spin coated at 4000 rpm for 20 s. Spiro-OMeTAD was doped with bis(trifluoromethylsulfonyl)imide lithium salt (Li-TFSI, Sigma-Aldrich), tris(2-(1H-pyrazol-1-yl)-4-tert-butylpyridine)- cobalt(III) tris(bis(trifluoromethylsulfonyl)imide) (FK209, Dynamo) and 4-tert-Butylpyridine (TBP, Sigma-Aldrich). The molar ratio of additives for spiro-OMeTAD was: 0.5, 0.03 and 3.3 for Li-TFSI, FK209 and TBP respectively. Finally, 70-80 nm of gold top electrode was thermally evaporated under high vacuum.

### Example 8 - Test procedures

*Charge extraction and transport time techniques*: Charge extraction and electron transport times in perovskite solar cell (PSC) devices as a function of open-circuit voltages were measured via DYENAMO Toolbox System. The system mainly consists of a white LED light source (Seoul Semiconductors), a 16-bit resolution digital acquisition board in order to record voltage traces and a current amplifier. For charge extraction, firstly, the PSCs were kept at open-circuit conditions and then they were illuminated by the light source. After 1 second the light was turned off and the device was switched to short-circuit condition. The total charge was obtained through the integration of current with respect to time. The complete charge-potential curve was obtained by using different light intensities. In transport time measurements, the light source was controlled by a modulated current on top of a bias current and short-circuit current response was measured. The transport times were obtained by fitting parameters of short-circuit current response curves.

*Photovoltaic device testing*: The solar cells were measured using a 450 W Xenon light source. The spectral mismatch between AM1.5G and the simulated illumination was reduced by the use of a Schott K113 Tempax filter (Präzisions Glas & Optik GmbH). The light intensity was calibrated with a Si photodiode equipped with an IR-cutoff filter (KG3, Schott), and it was recorded during each measurement. Current-voltage characteristics of the cells were obtained by applying an external voltage bias while measuring the current response with a digital source meter. The voltage scan rate was 10 mV s⁻¹ and no device preconditioning, such as light soaking or forward voltage bias applied for long time, was applied before starting the measurement. The starting voltage was determined as the potential at which the cells furnish 1 mA in forward bias, no equilibration time was used. The cells were masked with a black metal mask (0.16 cm²) to fix the active area and reduce the influence of the scattered light. The current was matched according to the intensity of the light source. Incident photon to current efficiency (IPCE) spectra were recorded using the Ariadne system (Cicci Research). A nonreflective metallic mask with an aperture of 0.16 cm² was used during both measurements.

*Perovskite characterization*: A ZEISS Merlin HR-SEM was used to characterize the morphology of the device top view and cross-section. TiO₂ particles were characterized by a high-resolution transmission electron microscope. The composition of TiO₂ nanoparticles were characterized by the energy-dispersive X-ray (EDX) spectra obtained in scanning transmission electron microscopy (STEM) mode with Technai Osiris. X-ray diffraction (XRD) were recorded on an X'Pert MPD PRO (Panalytical) equipped with a ceramic tube (Cu anode, λ = 1.54060 Å), a secondary graphite (002) monochromator and a RTMS X'Celerator (Panalytical).in an angle range of 2θ = 5° to 60° under ambient condition. Absorption spectral measurements were recorded using Varian Cary5 UV-visible spectrophotometer. Photoluminescence spectra were obtained with Fluorolog 322 with the range of wavelength from 620 to 850nm by exciting at 460nm. The samples were mounted at 60° and the emission recorded at 90° from the incident beam path. The time-resolved photoluminescence (TRPL) is incorporated into the same Fluorolog-322 spectrofluorometer. The exciting source is now a NANOLed 408 nm pulsed diode laser with a pulse width of less than 200 ps and repetition rate of 1 MHz.

*Impedance spectroscopy*: Impedance spectroscopy (IS) measurement were carried out by using a potentiostat with white LED as a light source. 20 mV of sinusoidal AC voltage with the frequency ranging from 1 MHz to 1 Hz was put on the DC voltage from 0 V to 0.9 V where the voltage step was 100 mV. The resulting data was fitted using a Z-view software with a simplified equivalent circuit which was comprised of a resistance and two R-C components (resistance and capacitance in parallel) in series. A metal aperture mask was attached to device during the IS measurements to avoid any scattering effect.

### Example 9 - Effect of Cs doping on perovskite solar cells/photovoltaic cells

To explore the effect of CsX doped mp-TiO₂ on the photovoltaic performance of PSCs, devices with the architecture of FTO/cp-TiO₂/mp-TiO₂/Perovskite/spiro-OMeTAD/Au were prepared. Table 2 below shows the results of current density-voltage (*J-V*) curves for the Rb/Cs/FA_{0.85} MA_{0.15} perovskite devices with the pristine mp-TiO₂ (Control), Csl doped mp-TiO₂ (Csl) and CsBr doped mp-TiO₂ (CsBr).

**Table 2. Effect of Cs doping on photovoltaic cells**

| Mesoporous TiO2 | Voc (V) | Jsc (mA/cm²) | FF | PCE (%) |
|---|---|---|---|---|
| Untreated | 1.158 | 21.5 | 0.78 | 19.4 |
| Csl | 1.189 | 21.5 | 0.8 | 20.4 |
| CsBr | 1.205 | 21.8 | 0.79 | 20.7 |

| | | | | |
|---|---|---|---|---|
| Voc = open-circuit voltage Jsc = short-circuit current FF = fill factor PCE = power conversion efficiency | | | | |

The improved *V_{oc}* and short circuit current (*J_{sc}*) and fill factor (FF) were observed in the devices with Cs doped mp-TiO₂ than non-doped one. Hysteresis of devices tends to become smaller using CsBr (4.5%) and CsI (5.2%) compared to control (10.6%). The percentage of hysteresis is determined by 100x {PCE(reverse scan)-PCE(forward scan)}/PCE(reverse scan). Statistics of device performance with Rb/Cs/FA₁₋ₓMAₓ perovskite on various substrates convince that PSCs are more efficient with CsBr than CsI. As the Cs doping passivated surface traps and reduced recombination in ESLs, the devices produced enhanced performance in PCEs.

The best perovskite composition for CsBr doped mp-TiO₂ was obtained by tuning the ratio of MAPbBr₃ to FAPbI₃ from 0 to 0.15. The average of *V_{oc}* and *J_{sc}* obtained from 15 devices with CsBr mp-TiO₂ showed a tradeoff between *V_{oc}* and *J_{sc}*. The best perovskite composition for CsBr doped mp-TiO₂ is achieved when x = 0.05, this is 10% less than our previous best composition on Li-treated mp-TiO₂. Solar cell devices with optimized conditions presented current *J-V* curves of the champion device with the composition Rb/Cs/FA_{0.95}MA_{0.05} under standard AM 1.5G sunlight at 100 mW/cm². The efficiency scanned in forward bias direction was 21.4% with an open-circuit voltage (V_{oc}) of 1.141 V, a short-circuit current density (*J_{sc}*) of 22.8 mA/cm², and a fill factor (FF) of 0.80 with negligible hysteresis (less than 4%). The *J_{sc}* was confirmed by the integration of the incident photon-to-current efficiency (IPCE).

## Claims

1. A semiconductor-absorber composite (10) comprising:
a mesoporous titania comprising titania particles (12); wherein the titania particles (12) comprise anatase;
halogen atoms disposed on a surface (16) of the titania particles (12); and
photoactive perovskite (18) in physical contact with at least a portion of the surface (20) of the titania particles (12), alternatively in physical contact with 50% to 100% of the surface (20), or alternatively in physical contact with the entire surface (20);
wherein the halogen atoms comprise halide ions selected from the group consisting of iodide, bromide, chloride, fluoride, and combinations thereof in an amount of 0.005 - 6.0 wt%.

2. The semiconductor-absorber composite (10) of claim 1, further comprising at least one of lead and alkali metal atoms disposed on a surface (16) of the titania particles (12); optionally wherein
(a) the at least one of lead and alkali metal atoms are additionally dispersed in the bulk of the titania particles (12); and/or
(b) the alkali metal atoms are selected from the group consisting of lithium, cesium, rubidium, and combinations thereof.

3. The semiconductor-absorber composite (10) of claim 1 or claim 2, wherein:
(a) greater than 95% of the titania particles (12) have a diameter between 2 and 100 nm; and/or
(b) greater than 98% of the titania particles (12) have a diameter between 50 and 70 nm; and/or
(c) the mesoporous titania contains pores having an average diameter of between 1 and 100 nm.

4. The semiconductor-absorber composite (10) of any one of claims 1-3, wherein
(a) the halogen atoms comprise halide ions selected from the group consisting of iodide, bromide, chloride, fluoride, and combinations thereof in an amount selected from the group consisting of 1.0 - 5.0 wt%, 1.5 - 3.5 wt% and 0.015 - 1.5wt%; and/or
(b) the halogen atoms comprise iodide; and/or
(c) the halogen atoms are additionally dispersed in the bulk of the titania particles (12).

5. The semiconductor-absorber composite (10) of any one of claims 1-4, wherein
(a) the photoactive perovskite (18) comprises a compound having the formula [A][B][X]₃ wherein [A] is a monovalent cation, [B] is a divalent metal cation, and [X] is a halide or mixture of halide anions; and/or
(b) the photoactive perovskite (18) comprises a compound having the formula [A][B][X]₃ wherein [A] is a monovalent cation, [B] is a divalent metal cation, [X] is a halide or mixture of halide anions, and the compound is doped with monovalent cations in the [A] position, wherein the monovalent cation is selected from the group consisting of cesium, lithium, rubidium, and combinations thereof.

6. The semiconductor-absorber composite (10) of any one of claims 1-5, wherein the titania particles (12) are doped with cations selected from the group consisting of cesium, lithium, rubidium, lead, and combinations thereof.

7. The semiconductor-absorber composite (10) of any one of claims 1-5, wherein the photoactive perovskite (18) comprises methyl ammonium lead trihalide, or comprises methyl ammonium lead triiodide (MALI).

8. The semiconductor-absorber composite (10) of any one of claims 1-7, wherein
(a) voids between the titania particles (12) are at least partly filled with the photoactive perovskite (18), alternatively 50% to 100% filled with photoactive perovskite (18), or alternatively completely filled with photoactive perovskite (18); or
(b) voids between the titania particles (12) are at least partly filled with a hole transport material (30), alternatively in physical contact with 50% to 100% of the surface (16), or alternatively in physical contact with the entire surface (16).

9. A method of making a semiconductor-absorber composite of any one of claims 1-7, comprising:
mixing an aqueous gel of titania nanoparticles with a halide compound to produce a surface treated mesoporous titania; drying and milling the surface treated mesoporous titania; and adding photosensitive perovskite to at least a portion of the surfaces of the surface treated mesoporous titania, alternatively adding photosensitive perovskite to 50% to 100% of the surface, or alternatively adding photosensitive perovskite to the entire surface.

10. A method of making a semiconductor-absorber composite of any one of claims 1-7, comprising:
heating an aqueous solution of a water soluble titanium compound, an organic acid at an acid to titanium molar ratio of 0.02 to 0.2, and a halide compound to produce a halide-containing mesoporous titania;
drying and milling the halide-containing mesoporous titania; and adding photosensitive perovskite to a portion of the surfaces of the halide-containing mesoporous titania, alternatively adding photosensitive perovskite to 50% to 100% of the surface, or alternatively adding photosensitive perovskite to the entire surface.

11. The method of claim 9 or 10, wherein
(a) the halide compound is selected from the group consisting of iodides, chlorides, bromides, and combinations thereof; and/or
(b) the halide compound is selected from the group consisting of halide acids, halide salts, and combinations thereof.

12. The method of any one of claims 9-11, wherein
(a) the halide compound comprises hydrogen iodide; or
(b) the halide compound comprises an organic halide; or
(c) the halide compound comprises at least one of an alkaline metal halide and a lead halide; optionally wherein the halide compound is selected from the group consisting of LiI, CsI, RbI, LiCl, CsCl, RbCl, LiBr, CsBr, RbBr, PbI₂, PbCl₂, PbBr₂ and combinations thereof.

13. The semiconductor-absorber composite (10) of any one of claims 1 to 7 further comprising a hole transport material (30) impregnating the semiconductor-absorber composite (10); optionally wherein
(a) the hole transport material (30) comprises an organic compound selected from the group consisting 2,2',7,7'-tetrakis[N,N-di(4-methoxyphenyl)amino]-9,9'-spirobifluorene (spiro-MeOTAD); poly(3-hexylthiophene-2,5-diyl) (P3HT); poly[2,6-(4,4-bis-(2-ethylhexyl)-4H-cyclopenta [2,I-*b*;3,4-*b*')']dithiophene)-*alt*-4,7(2,I,3-benzothiadiazole)] (PCPDTBT); and poly[bis(4-phenyl)(2,4,6-trimethylphenyl)amine] (PTAA)); or
(b) the hole transport material (30) comprises an inorganic oxide p-type semiconductor.

14. A photovoltaic cell (22) comprising:
a light absorbing layer (24) comprising the semiconductor-absorber composite (10) of any one of claims 1-7;
an anode contact layer (26); and
a hole blocking layer (28) between the light absorbing layer (24) and the anode contact layer (26), the hole blocking layer (28) comprising an n-type oxide semi-conductor in electrical contact with the anode contact layers (26) and having halogen atoms disposed on at least a portion of the surfaces thereof, alternatively on 50% to 100% of the surface, or alternatively on the entire surface; optionally
wherein the hole blocking layers (28) comprises titania nanoparticles having halogen atoms disposed on at least a portion of the surfaces thereof, alternatively on 50% to 100% of the surface, or alternatively on the entire surface.

15. The photovoltaic cell (22) of claim 14, wherein
(a) halogen atoms comprise halide ions selected from the group consisting of iodide, bromide, fluoride, chloride, and combinations thereof in an amount selected from the group consisting of 0.005 - 6.0 wt%, 1.0 - 5.0 wt%, 1.5 - 3.5 wt% and 0.015 - 1.5wt%; and/or
(b) the halogen atoms comprise iodide; and/or
(c) the halogen atoms are additionally dispersed in the bulk of the titania particles (12).

16. The photovoltaic cell (22) of claim 14 or 15, wherein the hole blocking layer (28) further comprises at least one of alkali metal atoms and lead atoms disposed on at least a portion of the surfaces thereof; optionally wherein
(a) the alkali metal atoms are selected from the group consisting of Li, Cs, Rb, and combinations thereof; and/or
(b) the at least one of alkali metal atoms and lead atoms are additionally dispersed in the bulk of the titania particles (12).

17. The photovoltaic cell (22) of any one of claims 14-16, wherein the mesoporous titania (12) is doped with at least one of lead ions and monovalent cations selected from the group consisting of cesium, lithium, rubidium, and combinations thereof.

18. The photovoltaic cell (22) of any one of claims 14-16, wherein
(a) the photoactive perovskite (18) comprises a compound having the formula [A][B][X]₃ wherein [A] is a monovalent cation, [B] is a divalent metal cation, and [X] is a halide or mixture of halide anions; and/or
(b) the photoactive perovskite (18) comprises methyl ammonium lead trihalide.

19. The photovoltaic cell (22) of any one of claims 14-18, wherein the photoactive perovskite (18) comprises a compound having the formula [A][B][X]₃ wherein [A] is a monovalent cation, [B] is a divalent metal cation, [X] is a halide or mixture of halide anions, and the compound is doped with monovalent cations in the [A] position, wherein the monovalent cations are selected from the group consisting of cesium, lithium, rubidium, and combinations thereof.

## Patentansprüche

1. Halbleiter-Absorber-Verbundstoff (10), umfassend:
ein mesoporöses Titandioxid, das Titandioxid-Partikel (12) umfasst; wobei die Titandioxid-Partikel (12) Anatas umfassen;
Halogenatome, die auf einer Oberfläche (16) der Titandioxid-Partikel (12) angeordnet sind; und
photoaktiven Perowskit (18) in physischem Kontakt mit zumindest einem Teil der Oberfläche (20) der Titandioxid-Partikel (12), alternativ in physischem Kontakt mit 50 % bis 100 % der Oberfläche (20) oder alternativ in physischem Kontakt mit der gesamten Oberfläche (20);
wobei die Halogenatome Halogenidionen, die ausgewählt sind aus der Gruppe bestehend aus Iodid, Bromid, Chlorid, Fluorid und Kombinationen davon, in einer Menge von 0,005-6,0 Gew.-% umfassen.

2. Halbleiter-Absorber-Verbundstoff (10) nach Anspruch 1, ferner umfassend Blei- und/oder Alkalimetallatome, die auf einer Oberfläche (16) der Titandioxid-Partikel (12) angeordnet sind; wobei gegebenenfalls
(a) die Blei- und/oder Alkalimetallatome zusätzlich in der Menge der Titandioxid-Partikel (12) dispergiert sind; und/oder
(b) die Alkalimetallatome ausgewählt sind aus der Gruppe bestehend aus Lithium, Caesium, Rubidium und Kombinationen davon.

3. Halbleiter-Absorber-Verbundstoff (10) nach Anspruch 1 oder Anspruch 2, wobei:
(a) mehr als 95 % der Titandioxid-Partikel (12) einen Durchmesser zwischen 2 und 100 nm aufweisen; und/oder
(b) mehr als 98 % der Titandioxid-Partikel (12) einen Durchmesser zwischen 50 und 70 nm aufweisen; und/oder
(c) das mesoporöse Titandioxid Poren enthält, die einen durchschnittlichen Durchmesser zwischen 1 und 100 nm aufweisen.

4. Halbleiter-Absorber-Verbundstoff (10) nach einem der Ansprüche 1-3, wobei
(a) die Halogenatome Halogenidionen, die ausgewählt sind aus der Gruppe bestehend aus Iodid, Bromid, Chlorid, Fluorid und Kombinationen davon, in einer Menge umfassen, die ausgewählt ist aus der Gruppe bestehend aus 1,0-5,0 Gew.-%, 1,5-3,5 Gew.-% und 0,015-1,5 Gew.-%; und/oder
(b) die Halogenatome Iodid umfassen; und/oder
(c) die Halogenatome zusätzlich in der Menge der Titandioxid-Partikel (12) dispergiert sind.

5. Halbleiter-Absorber-Verbundstoff (10) nach einem der Ansprüche 1-4, wobei
(a) der photoaktive Perowskit (18) eine Verbindung mit der Formel [A][B][X]₃ umfasst, wobei [A] für ein einwertiges Kation steht, [B] für ein zweiwertiges Metallkation steht und [X] für ein Halogenid oder ein Gemisch von Halogenidanionen steht; und/oder
(b) der photoaktive Perowskit (18) eine Verbindung mit der Formel [A][B][X]₃ umfasst, wobei [A] für ein einwertiges Kation steht, [B] für ein zweiwertiges Metallkation steht, [X] für ein Halogenid oder ein Gemisch von Halogenidanionen steht und die Verbindung in der [A]-Position mit einwertigen Kationen dotiert ist, wobei das einwertige Kation ausgewählt ist aus der Gruppe bestehend aus Caesium, Lithium, Rubidium und Kombinationen davon.

6. Halbleiter-Absorber-Verbundstoff (10) nach einem der Ansprüche 1-5, wobei die Titandioxid-Partikel (12) mit Kationen dotiert sind, die ausgewählt sind aus der Gruppe bestehend aus Caesium, Lithium, Rubidium, Blei und Kombinationen davon.

7. Halbleiter-Absorber-Verbundstoff (10) nach einem der Ansprüche 1-5, wobei der photoaktive Perowskit (18) Methylammoniumbleitrihalogenid umfasst oder Methylammoniumbleitriiodid (MALI - methyl ammonium lead triiodide) umfasst.

8. Halbleiter-Absorber-Verbundstoff (10) nach einem der Ansprüche 1-7, wobei
(a) Hohlräume zwischen den Titandioxid-Partikeln (12) zumindest teilweise mit dem photoaktiven Perowskit (18) gefüllt sind, alternativ zu 50 % bis 100 % mit photoaktivem Perowskit (18) gefüllt sind oder alternativ vollständig mit photoaktivem Perowskit (18) gefüllt sind; oder
(b) Hohlräume zwischen den Titandioxid-Partikeln (12) zumindest teilweise mit einem Löcher transportierenden Material (30) gefüllt sind, alternativ in physischem Kontakt mit 50 % bis 100 % der Oberfläche (16) oder alternativ in physischem Kontakt mit der gesamten Oberfläche (16).

9. Verfahren zum Herstellen eines Halbleiter-Absorber-Verbundstoffs nach einem der Ansprüche 1-7, umfassend:
Mischen eines wässrigen Gels von Titandioxid-Nanopartikeln mit einer Halogenidverbindung, um ein oberflächenbehandeltes mesoporöses Titandioxid zu bilden;
Trocknen und Mahlen des oberflächenbehandelten mesoporösen Titandioxids; und Zugeben von photoempfindlichem Perowskit zu zumindest einem Teil der Oberflächen des oberflächenbehandelten mesoporösen Titandioxids, alternativ Zugeben von photoempfindlichem Perowskit zu 50 % bis 100 % der Oberfläche oder alternativ Zugeben von photoempfindlichem Perowskit zu der gesamten Oberfläche.

10. Verfahren zum Herstellen eines Halbleiter-Absorber-Verbundstoffs nach einem der Ansprüche 1-7, umfassend:
Erwärmen einer wässrigen Lösung einer wasserlöslichen Titanverbindung, einer organischen Säure in einem Säure-Titan-Molverhältnis von 0,02 bis 0,2 und einer Halogenidverbindung, um ein Halogenid enthaltendes mesoporöses Titandioxid zu bilden; Trocknen und Mahlen des Halogenid enthaltenden mesoporösen Titandioxids; und
Zugeben von photoempfindlichem Perowskit zu einem Teil der Oberflächen des Halogenid enthaltenden mesoporösen Titandioxids, alternativ Zugeben von photoempfindlichem Perowskit zu 50 % bis 100 % der Oberfläche oder alternativ Zugeben von photoempfindlichem Perowskit zu der gesamten Oberfläche.

11. Verfahren nach Anspruch 9 oder 10, wobei
(a) die Halogenidverbindung ausgewählt ist aus der Gruppe bestehend aus Iodiden, Chloriden, Bromiden und Kombinationen davon; und/oder
(b) die Halogenidverbindung ausgewählt ist aus der Gruppe bestehend aus Halogenidsäuren, Halogenidsalzen und Kombinationen davon.

12. Verfahren nach einem der Ansprüche 9-11, wobei
(a) die Halogenidverbindung Wasserstoffiodid umfasst; oder
(b) die Halogenidverbindung ein organisches Halogenid umfasst; oder
(c) die Halogenidverbindung ein Alkalimetallhalogenid und/oder ein Bleihalogenid umfasst; wobei die Halogenidverbindung gegebenenfalls ausgewählt ist aus der Gruppe bestehend aus LiI, CsI, RbI, LiCl, CsCl, RbCl, LiBr, CsBr, RbBr, PbI₂, PbCl₂, PbBr₂ und Kombinationen davon.

13. Halbleiter-Absorber-Verbundstoff (10) nach einem der Ansprüche 1 bis 7, ferner umfassend ein Löcher transportierendes Material (30), das den Halbleiter-Absorber-Verbundstoff (10) durchdringt; wobei gegebenenfalls
(a) das Löcher transportierende Material (30) eine organische Verbindung umfasst, die ausgewählt ist aus der Gruppe bestehend aus 2,2',7,7'-Tetrakis[N,N-di(4-methoxyphenyl)amino]-9,9'-spirobifluoren (spiro-MeOTAD); Poly(3-hexylthiophen-2,5-diyl) (P3HT); Poly[2,6-(4,4-bis-(2-ethylhexyl)-4H-cyclopenta[2,1-*b*;3,4-*b*')']dithiophen)-*alt*-4,7(2,1,3-benzothiadiazol)] (PCPDTBT); und Poly[bis(4-phenyl)(2,4,6-trimethylphenyl)amin] (PTAA)); oder
(b) das Löcher transportierende Material (30) einen anorganischen p-Oxid-Halbleiter umfasst.

14. Photovoltaische Zelle (22), umfassend:
eine lichtabsorbierende Schicht (24), die den Halbleiter-Absorber-Verbundstoff (10) nach einem der Ansprüche 1-7 umfasst;
eine Anodenkontaktschicht (26); und
eine Löcher blockierende Schicht (28) zwischen der lichtabsorbierenden Schicht (24) und der Anodenkontaktschicht (26), wobei die Löcher blockierende Schicht (28) einen n-Oxid-Halbleiter in elektrischem Kontakt mit den Anodenkontaktschichten (26) umfasst und Halogenatome aufweist, die zumindest auf einem Teil der Oberflächen davon angeordnet sind, alternativ auf 50 % bis 100 % der Oberfläche oder alternativ auf der gesamten Oberfläche; wobei
gegebenenfalls die Löcher blockierende Schicht (28) Titandioxid-Nanopartikel umfasst, die Halogenatome aufweisen, die zumindest auf einem Teil der Oberflächen davon angeordnet sind, alternativ auf 50 % bis 100 % der Oberfläche oder alternativ auf der gesamten Oberfläche.

15. Photovoltaische Zelle (22) nach Anspruch 14, wobei
(a) Halogenatome Halogenidionen, die ausgewählt sind aus der Gruppe bestehend aus Iodid, Bromid, Fluorid, Chlorid und Kombinationen davon, in einer Menge umfassen, die ausgewählt ist aus der Gruppe bestehend aus 0,005-6,0 Gew.-%, 1,0-5,0 Gew.-%, 1,5-3,5 Gew.-% und 0,015-1,5 Gew.-%; und/oder
(b) die Halogenatome Iodid umfassen; und/oder
(c) die Halogenatome zusätzlich in der Menge der Titandioxid-Partikel (12) dispergiert sind.

16. Photovoltaische Zelle (22) nach Anspruch 14 oder 15, wobei die Löcher blockierende Schicht (28) ferner Alkalimetallatome und/oder Bleiatome umfasst, die zumindest auf einem Teil der Oberflächen davon angeordnet sind; wobei gegebenenfalls
(a) die Alkalimetallatome ausgewählt sind aus der Gruppe bestehend aus Li, Cs, Rb und Kombinationen davon; und/oder
(b) die Alkalimetallatome und/oder Bleiatome zusätzlich in der Menge der Titandioxid-Partikel (12) dispergiert sind.

17. Photovoltaische Zelle (22) nach einem der Ansprüche 14-16, wobei das mesoporöse Titandioxid (12) mit Bleiionen und/oder einwertigen Kationen dotiert ist, die ausgewählt sind aus der Gruppe bestehend aus Caesium, Lithium, Rubidium und Kombinationen davon.

18. Photovoltaische Zelle (22) nach einem der Ansprüche 14-16, wobei
(a) der photoaktive Perowskit (18) eine Verbindung mit der Formel [A][B][X]₃ umfasst, wobei [A] für ein einwertiges Kation steht, [B] für ein zweiwertiges Metallkation steht und [X] für ein Halogenid oder ein Gemisch von Halogenidanionen steht; und/oder
(b) der photoaktive Perowskit (18) Methylammoniumbleitrihalogenid umfasst.

19. Photovoltaische Zelle (22) nach einem der Ansprüche 14-18, wobei der photoaktive Perowskit (18) eine Verbindung mit der Formel [A][B][X]₃ umfasst, wobei [A] für ein einwertiges Kation steht, [B] für ein zweiwertiges Metallkation steht, [X] für ein Halogenid oder ein Gemisch von Halogenidanionen steht und die Verbindung in der [A]-Position mit einwertigen Kationen dotiert ist, wobei die einwertigen Kationen ausgewählt sind aus der Gruppe bestehend aus Caesium, Lithium, Rubidium und Kombinationen davon.

## Revendications

1. Composite de semi-conducteur-absorbeur (10) comprenant :
des particules de dioxyde de titane comprenant du dioxyde de titane mésoporeux (12) ; dans lequel les particules de dioxyde de titane (12) comprennent de l'anatase ;
des atomes d'halogène disposés sur une surface (16) des particules de dioxyde de titane (12) ; et
une pérovskite photoactive (18) en contact physique avec au moins une partie de la surface (20) des particules de dioxyde de titane (12), en variante en contact physique avec 50 % à 100 % de la surface (20), ou en variante en contact physique avec toute la surface (20) ;
dans lequel les atomes d'halogène comprennent des ions halogénure choisis dans le groupe constitué par l'iodure, bromure, chlorure, fluorure et les combinaisons de ceux-ci en une quantité de 0,005-6,0 % en poids.

2. Composite de semi-conducteur-absorbeur (10) selon la revendication 1, comprenant en outre des atomes de plomb et/ou de métal alcalin disposés sur une surface (16) des particules de dioxyde de titane (12) ; éventuellement dans lequel
(a) les atomes de plomb et/ou de métal alcalin sont de plus dispersés dans la masse des particules de dioxyde de titane (12) ; et/ou
(b) les atomes de métal alcalin sont choisis dans le groupe constitué par le lithium, le césium, le rubidium et les combinaisons de ceux-ci.

3. Composite de semi-conducteur-absorbeur (10) selon la revendication 1 ou la revendication 2, dans lequel :
(a) plus de 95 % des particules de dioxyde de titane (12) ont un diamètre compris entre 2 et 100 nm ; et/ou
(b) plus de 98 % des particules de dioxyde de titane (12) ont un diamètre compris entre 50 et 70 nm ; et/ou
(c) le dioxyde de titane mésoporeux contient des pores ayant un diamètre moyen compris entre 1 et 100 nm.

4. Composite de semi-conducteur-absorbeur (10) selon l'une quelconque des revendications 1-3, dans lequel
(a) les atomes d'halogène comprennent des ions halogénure choisis dans le groupe constitué par l'iodure, bromure, chlorure, fluorure et les combinaisons de ceux-ci en une quantité choisie dans le groupe constitué par 1,0-5,0 % en poids, 1,5-3,5 % en poids et 0,015-1,5 % en poids ; et/ou
(b) les atomes d'halogène comprennent des ions iodure ; et/ou
(c) les atomes d'halogène sont de plus dispersés dans la masse des particules de dioxyde de titane (12).

5. Composite de semi-conducteur-absorbeur (10) selon l'une quelconque des revendications 1-4, dans lequel
(a) la pérovskite photoactive (18) comprend un composé répondant à la formule [A][B][X]₃ dans laquelle [A] est un cation monovalent, [B] est un cation métallique divalent et [X] est un anion halogénure ou un mélange d'anions halogénure ; et/ou
(b) la pérovskite photoactive (18) comprend un composé répondant à la formule [A][B][X]₃ dans laquelle [A] est un cation monovalent, [B] est un cation métallique divalent, [X] est un anion halogénure ou un mélange d'anions halogénure et le composé est dopé avec des cations monovalents dans la position [A], dans lequel le cation monovalent est choisi dans le groupe constitué par le césium, le lithium, le rubidium et les combinaisons de ceux-ci.

6. Composite de semi-conducteur-absorbeur (10) selon l'une quelconque des revendications 1-5, dans lequel les particules de dioxyde de titane (12) sont dopées avec des cations choisis dans le groupe constitué par le césium, le lithium, le rubidium, le plomb et les combinaisons de ceux-ci.

7. Composite de semi-conducteur-absorbeur (10) selon l'une quelconque des revendications 1-5, dans lequel la pérovskite photoactive (18) comprend un trihalogénure de plomb et de méthylammonium ou comprend du triiodure de plomb et de méthylammonium (MALI).

8. Composite de semi-conducteur-absorbeur (10) selon l'une quelconque des revendications 1-7, dans lequel
(a) les vides entre les particules de dioxyde de titane (12) sont au moins en partie remplis de la pérovskite photoactive (18), en variante remplis à hauteur de 50 % à 100 % de pérovskite photoactive (18), ou en variante complètement remplis de pérovskite photoactive (18) ; ou
(b) les vides entre les particules de dioxyde de titane (12) sont au moins en partie remplis d'un matériau de transport de trous (30), en variante en contact physique avec 50 % à 100 % de la surface (16), ou en variante en contact physique avec toute la surface (16).

9. Procédé de fabrication d'un composite de semi-conducteur-absorbeur selon l'une quelconque des revendications 1-7, comprenant : le mélange d'un gel aqueux de nanoparticules de dioxyde de titane avec un composé halogénure pour produire un dioxyde de titane mésoporeux traité en surface ; le séchage et le broyage du dioxyde de titane mésoporeux traité en surface ; et l'ajout de pérovskite photosensible sur au moins une partie des surfaces du dioxyde de titane mésoporeux traité en surface, en variante l'ajout de pérovskite photosensible sur 50 % à 100 % de la surface, ou en variante l'ajout de pérovskite photosensible sur toute la surface.

10. Procédé de fabrication d'un composite de semi-conducteur-absorbeur selon l'une quelconque des revendications 1-7, comprenant : le chauffage d'une solution aqueuse d'un composé hydrosoluble du titane, d'un acide organique en un rapport molaire acide sur titane de 0,02 à 0,2 et d'un composé halogénure pour produire un dioxyde de titane mésoporeux contenant des ions halogénure ; le séchage et le broyage du dioxyde de titane mésoporeux contenant des ions halogénure ; et l'ajout de pérovskite photosensible sur une partie des surfaces du dioxyde de titane mésoporeux contenant des ions halogénure, en variante l'ajout de pérovskite photosensible sur 50 % à 100 % de la surface, ou en variante l'ajout de pérovskite photosensible sur toute la surface.

11. Procédé selon la revendication 9 ou 10, dans lequel
(a) le composé halogénure est choisi dans le groupe constitué par les iodures, les chlorures, les bromures et les combinaisons de ceux-ci ; et/ou
(b) le composé halogénure est choisi dans le groupe constitué par les acides halogénhydriques, les sels halogénures et les combinaisons de ceux-ci.

12. Procédé selon l'une quelconque des revendications 9-11, dans lequel
(a) le composé halogénure comprend de l'acide iodhydrique ; ou
(b) le composé halogénure comprend un halogénure organique ; ou
(c) le composé halogénure comprend un halogénure de métal alcalin et/ou un halogénure de plomb ; éventuellement dans lequel le composé halogénure est choisi dans le groupe constitué par LiI, CsI, RbI, LiCl, CsCl, RbCl, LiBr, CsBr, RbBr, PbI₂, PbCl₂, PbBr₂ et les combinaisons de ceux-ci.

13. Composite de semi-conducteur-absorbeur (10) selon l'une quelconque des revendications 1 à 7 comprenant en outre un matériau de transport de trous (30) imprégnant le composite de semi-conducteur-absorbeur (10) ; éventuellement dans lequel
(a) le matériau de transport de trous (30) comprend un composé organique choisi dans le groupe constitué par le 2,2,7,7-tétrakis[*N*,*N*-di(4-méthoxyphényl)amino]-9,9'-spirobifluorène (spiro-MeOTAD) ; le poly(3-hexylthiophène-2,5-diyl) (P3HT) ; le poly[2,6-(4,4-bis(2-éthylhexyl)-4*H-*cyclopenta[2,1-*b*;3,4-*b*')']dithiophène)-*alt*-4,7-(2,1,3-benzothiadiazole)] (PCPDTBT) ; et la poly[bis(4-phényl)(2,4,6-triméthylphényl)amine] (PTAA)) ; ou
(b) le matériau de transport de trous (30) comprend un semi-conducteur de type p en oxyde inorganique.

14. Cellule photovoltaïque (22) comprenant :
une couche absorbant la lumière (24) comprenant le composite de semi-conducteur-absorbeur (10) selon l'une quelconque des revendications 1-7 ;
une couche de contact anodique (26) ; et
une couche de blocage de trous (28) entre la couche absorbant la lumière (24) et la couche de contact anodique (26), la couche de blocage de trous (28) comprenant un semi-conducteur oxyde de type n en contact électrique avec les couches de contact anodiques (26) et ayant des atomes d'halogène disposés sur au moins une partie de ses surfaces, en variante sur 50 % à 100 % de la surface, ou en variante sur toute la surface ; éventuellement
dans laquelle la couche de blocage de trous (28) comprend des nanoparticules de dioxyde de titane ayant des atomes d'halogène disposés sur au moins une partie de leurs surfaces, en variante sur 50 % à 100 % de la surface, ou en variante sur toute la surface.

15. Cellule photovoltaïque (22) selon la revendication 14, dans laquelle
(a) les atomes d'halogène comprennent des ions halogénure choisis dans le groupe constitué par l'iodure, bromure, fluorure, chlorure et les combinaisons de ceux-ci en une quantité choisie dans le groupe constitué par 0,005-6,0 % en poids, 1,0-5,0 % en poids, 1,5-3,5 % en poids et 0,015-1,5 % en poids ; et/ou
(b) les atomes d'halogène comprennent des ions iodure ; et/ou
(c) les atomes d'halogène sont de plus dispersés dans la masse des particules de dioxyde de titane (12).

16. Cellule photovoltaïque (22) selon la revendication 14 ou 15, dans laquelle la couche de blocage de trous (28) comprend en outre des atomes de métal alcalin et/ou des atomes de plomb disposés sur au moins une partie de ses surfaces ; éventuellement dans laquelle
(a) les atomes de métal alcalin sont choisis dans le groupe constitué par Li, Cs, Rb et les combinaisons de ceux-ci ; et/ou
(b) les atomes de métal alcalin et/ou les atomes de plomb sont de plus dispersés dans la masse des particules de dioxyde de titane (12).

17. Cellule photovoltaïque (22) selon l'une quelconque des revendications 14-16, dans laquelle le dioxyde de titane mésoporeux (12) est dopé avec des ions plomb et/ou des cations monovalents choisis dans le groupe constitué par le césium, le lithium, le rubidium et les combinaisons de ceux-ci.

18. Cellule photovoltaïque (22) selon l'une quelconque des revendications 14-16, dans laquelle
(a) la pérovskite photoactive (18) comprend un composé répondant à la formule [A][B][X]₃ dans laquelle [A] est un cation monovalent, [B] est un cation métallique divalent et [X] est un anion halogénure ou un mélange d'anions halogénure ; et/ou
(b) la pérovskite photoactive (18) comprend un trihalogénure de plomb et de triméthylammonium.

19. Cellule photovoltaïque (22) selon l'une quelconque des revendications 14-18, dans laquelle la pérovskite photoactive (18) comprend un composé répondant à la formule [A][B][X]₃ dans laquelle [A] est un cation monovalent, [B] est un cation métallique divalent, [X] est un anion halogénure ou un mélange d'anions halogénure et le composé est dopé avec des cations monovalents dans la position [A], dans laquelle les cations monovalents sont choisis dans le groupe constitué par le césium, le lithium, le rubidium et les combinaisons de ceux-ci.
